(19) Europäisches Patentamt
European Patent Office
Office européen des brevets

(11) EP 2 956 974 B1

(12) EUROPÄISCHE PATENTSCHRIFT

(45) Veröffentlichungstag und Bekanntmachung des Hinweises auf die Patenterteilung:
07.06.2017 Patentblatt 2017/23

(51) Int Cl.:
*H01L 49/00* (2006.01)

(21) Anmeldenummer: 14704559.5

(22) Anmeldetag: 12.02.2014

(86) Internationale Anmeldenummer:
PCT/EP2014/052685

(87) Internationale Veröffentlichungsnummer:
WO 2014/124949 (21.08.2014 Gazette 2014/34)

(54) **STRAHLUNGSQUELLE UND VERFAHREN ZU DEREN BETRIEB**

RADIATION SOURCE AND METHOD FOR THE OPERATION THEREOF

SOURCE DE RAYONNEMENT ET SON PROCÉDÉ D'UTILISATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.02.2013 DE 102013202220**

(43) Veröffentlichungstag der Anmeldung:
**23.12.2015 Patentblatt 2015/52**

(73) Patentinhaber: **Fraunhofer-Gesellschaft zur Förderung der angewandten Forschung e.V.
80686 München (DE)**

(72) Erfinder: **BURENKOV, Alexander
91056 Erlangen (DE)**

(74) Vertreter: **Friese Goeden Patentanwälte PartGmbB
Widenmayerstraße 49
80538 München (DE)**

(56) Entgegenhaltungen:
**WO-A1-2013/016601 US-A1- 2008 212 975**

• **SHUR M S ET AL: "Plasma wave electronics: terahertz sources and detectors using two dimensional electronic fluid in high electron mobility transistors", TERAHERTZ ELECTRONICS PROCEEDINGS, 1998. THZ NINTY EIGHT. 1998 IEEE SI XTH INTERNATIONAL CONFERENCE ON LEEDS, UK 3-4 SEPT. 1998, NEW YORK, NY, USA,IEEE, US, 3. September 1998 (1998-09-03), Seiten 127-130, XP010314409, DOI: 10.1109/THZ.1998.731682 ISBN: 978-0-7803-4903-2**

**Beschreibung**

Die Erfindung betrifft eine Strahlungsquelle mit zumindest einem Halbleitersubstrat, auf welchem zumindest zwei Feldeffekttransistoren ausgebildet sind. Weiterhin betrifft die Erfindung ein Verfahren zur Erzeugung elektromagnetischer Strahlung mit einer Vakuumwellenlänge zwischen etwa 10 $\mu$m und etwa 1 mm, bei welchem eine Anordnung mit zumindest zwei Feldeffekttransistoren auf einem Halbleitersubstrat verwendet wird. Vorrichtungen und Verfahren der eingangs genannten Art können zur Erzeugung von ferninfraroter bzw. Terahertzstrahlung verwendet werden. Dieser Teil des elektromagnetischen Spektrums kann zur Spektroskopie, zur zerstörungsfreien Werkstoffprüfung, in der Sicherheitstechnik sowie in der Biologie und der Medizin verwendet werden.

Aus T. Otsuji, Y.M. Meziani, T. Nishimura, T. Suemitsu, W. Knap, E. Sano, T. Asano und V.V. Popov: "Emission of terahertz radiation from dual grating gate plasmon-resonant emitters fabricated with InGaP/InGaAs/GaAs material systems", J. Phys.: Condens. Matter 20 (2008) 384206, ist bekannt, einen Feldeffekttransistor mit einer gitterförmigen Gate-Elektrode auszustatten. Benachbarte Kontaktflächen der gitterförmigen Gate-Elektrode sind mit unterschiedlichen elektrischen Potentialen verbunden. Dies führt dazu, dass von dem im Kanal des Feldeffekttransistors fließenden Elektronenstrom Plasmonen angeregt werden. Die Plasmonen weisen Schwingungsfrequenzen zwischen etwa 600 Gigahertz und etwa 3 Terahertz auf, so dass entsprechende elektromagnetische Wellen angeregt werden können. Diese bekannte Strahlungsquelle weist jedoch den Nachteil auf, dass die Ausgangsleistung nur etwa 1 $\mu$W beträgt. Für einige technische Anwendungen ist jedoch eine Ausgangsleistung von etwa 1 mW erforderlich.

Aus Shur, M.S; Lu, J.-Q; Dyakonov, M.I: Plasma wave electronics: terahertz sources and detectors using two dimensional electronic fluid in high electron mobility transistors. Terahertz Electronics Proceedings, 1998. THz Ninety Eight. 1998 IEEE Sixth International Conference, S. 127-130, ist bekannt, dass Plasmonenschwingungen in einzelnen Feldeffekttransistoren durch einen elektrischen Strom zwischen Source- und Drainkontakt angeregt werden. Die Anregung von Plasmonenschwingungen erfordert eine hohe Beweglichkeit der Ladungsträger und einen ballistischen Elektronentransport im Kanal. Die Frequenz der in den Feldeffekttransistoren angeregten Plasmonenschwingungen, welche der Frequenz $f$ der emittierten elektromagnetischen Strahlung gleich ist, hat folgende Relation zur Ausbreitungsgeschwindigkeit von Oberflächenplasmonen s und der Gatelänge der Feldeffekttransistoren $L_G$

$$f = \frac{s \cdot (2k - 1)}{4 L_G}$$

wobei $k$ = 1, 2, 3 ... ist. Die Ausbreitungsgeschwindigkeit s von Oberflächenplasmonen ist in der Größenordnung von $10^6$ m/s, daher ergeben sich Frequenzen $f$ von Plasmonenwellen und der entsprechenden emittierten Strahlung im Terahertzbereich bei Gatelängen im Bereich von einigen Nanometern bis einigen Hundert Nanometern. Der Parameter k definiert dabei die Anzahl der Plasmonenhalbwellen, welche sich auf der Gatelänge der Feldeffekttransistoren $L_G$ ausbilden plus 0,5. Bei k = 1 bilden sich somit Plasmonenschwingungen aus, deren Wellenlänge dem vierfachen der Gatelänge $L_G$ entspricht. Für k = 2 bilden sich auf der Gatelänge $L_G$ 3/4 Wellenlängen der Plasmonenschwingung aus. WO2013/016601 A1 beschreibt einen Sender, bei dem sich mehrere Feldeffekt-Pfade zwischen gemeinsamen Source- und Drainkontakten befinden. Ausgehend vom Stand der Technik liegt der Erfindung somit die Aufgabe zugrunde, eine Strahlungsquelle für Ferninfrarot- bzw. Terahertzstrahlung bereitzustellen, welche eine größere Ausgangsleistung aufweist.

Die Aufgabe wird durch eine Strahlungsquelle gemäß Anspruch 1 und ein Verfahren gemäß Anspruch 16 gelöst. Erfindungsgemäß wird eine Strahlungsquelle vorgeschlagen, bei der mehrere Feldeffekttransistoren jeweils im ballistischen Bereich arbeiten und durch ihre periodische Anordnung plasmonische Schwingungen erzeugen, diese verstärken und als Terahertzstahlung auskoppeln. Hierzu kann ein Halbleitersubstrat und eine Bauelementearchitektur verwendet werden, die für Feldeffekttransistoren geeignet ist, sofern diese eine hinreichend gute Kombination aus hinreichend großer Ladungsträgerbeweglichkeit und hinreichend kleiner Kanallänge aufweisen. Solche Kombinationen sind nach dem gegenwärtigen Stand der Technik möglich.

Erfindungsgemäß wird eine Strahlungsquelle vorgeschlagen, welche zumindest zwei Feldeffekttransistoren auf einem Halbleitersubstrat zur Erzeugung von FIR-Strahlung verwendet. In der nachfolgenden Beschreibung wird der Begriff "Ferninfrarotstrahlung" oder FIR-Strahlung für elektromagnetische Strahlung mit einer Vakuumwellenlänge von etwa 10 $\mu$m bis etwa 1 mm verwendet. Es handelt sich dabei um Strahlung im sogenannten Terahertz-Gap des elektromagnetischen Spektrums, welche langwelliger ist als infrarote Strahlung und kurzwelliger als Mikrowellenstrahlung.

Die Strahlungsquelle ist auf einem Halbleitersubstrat aufgebaut. Das Halbleitersubstrat kann beispielsweise einen Elementhalbleiter enthalten, wie Silizium oder Germanium. In einigen Ausführungsformen der Erfindung enthält das Halbleitersubstrat zumindest ein Nitrid, beispielsweise Galliumnitrid oder Aluminiumnitrid. In einigen Ausführungsformen der Erfindung kann das Halbleitersubstrat eine ternäre oder quaternäre Verbindung eines Elementes der dritten Hauptgruppe des Periodensystems und Stickstoff enthalten. In anderen Ausführungsformen der Erfindung kann das Halbleitersubstrat zumindest eine Verbindung aus einem Element der dritten und einem Element der fünften Hauptgruppe enthalten. Das Element der dritten Hauptgruppe kann dabei ausgewählt sein aus Aluminium, Gallium oder Indium. Das Element der fünften Hauptgruppe kann ausgewählt sein aus Phosphor, Arsen oder Antimon. In einigen Ausführungsformen der Erfindung kann das Halbleitersubstrat zumindest eine ternäre oder quaternäre Verbindung aus Elementen der dritten und fünften Hauptgruppe enthalten oder daraus bestehen. In einigen Ausführungsformen der Erfindung kann das Halbleitersubstrat zumindest teilweise einen mehrschichtigen Aufbau aufweisen. Unterschiedliche Schichten können eine unterschiedliche Zusammensetzung aufweisen, so dass sich eine Halbleiterheterostruktur ergibt. Die Halbleiterheterostruktur kann die Ausbildung eines zweidimensionalen Elektronengases ermöglichen oder erleichtern.

Weiterhin enthält die Strahlungsquelle zumindest eine periodische Anordnung von zumindest zwei Feldeffekttransistoren. Jeder Feldeffekttransistor enthält jeweils eine Gateelektrode, einen Sourcekontakt und einen Drainkontakt. Die Gateelektrode, der Sourcekontakt und der Drainkontakt begrenzen einen Kanal, in welchem sich bei Betrieb der Vorrichtung ein Elektronenstrom ausbilden kann.

Die zumindest zwei Feldeffekttransistoren sind nebeneinander in Richtung der Achse Source-Drain auf dem Substrat angeordnet, wobei jeder Feldeffekttransistor genau eine Gateelektrode aufweist und zwischen zwei benachbarten Gate-elektroden zumindest ein Sourcekontakt und/oder zumindest ein Drainkontakt angeordnet ist.

Benachbarte Feldeffekttransistoren können jeweils zugeordnete Sourcekontakte (S) und Drainkontakte (D) aufweisen oder einen gemeinsamen Source- und Drainkontakt aufweisen. Demnach kann die periodische Reihenfolge der Kontakte auf der Substratoberfläche in einigen
Ausführungsformen .../Source/Gate/Drain/Gate/Source /Gate/Drain/... lauten. In anderen Ausführungsformen kann die Reihenfolge .../Source/Gate/Drain/Source/Gate/Drain/ Source/Gate/Drain/... lauten. In anderen Ausführungsformen kann die Reihenfolge .../Source/Source/Gate/Drain/Drain/Gate/ Source/Source/Gate/... lauten.

In einigen Ausführungsformen der Erfindung können die Kontakte zumindest teilweise im Volumen des Halbleitersubstrates angeordnet sein. In diesem Fall kann das Halbleitersubstrat für jeden Kontakt einen zugeordneten Graben aufweisen, welcher den Kontakt zumindest teilweise aufnimmt. In anderen Ausführungsformen der Erfindung können die Kontakte auf der Oberfläche eines Halbleitersubstrates abgeschieden werden, ehe weitere halbleitende Schichten auf die verbleibenden freien Flächenbereiche des Halbleitersubstrats abgeschieden werden. Üblicherweise handelt es sich bei den Source- und Drainkontakten um Ohm'sche Kontakte, d.h. es kann ein Ladungsträgeraustausch zwischen dem Kontakt und dem Halbleitersubstrat erfolgen, so dass der Übergangswiderstand zwischen dem Kontakt und dem Halbleiter gering ist. Dies kann erreicht werden, indem die Austrittsarbeit des Metalls oder der Legierung des Kontaktes und/oder die Ladungsträgerdichte eines an den Kontakt angrenzenden Bereichs des Halbleitersubstrates so gewählt wird, dass sich ein gewünschter Wert der Schottkybarriere ergibt.

Weiterhin weist die erfindungsgemäße Strahlungsquelle zumindest eine erste Gate-Elektrode und zumindest eine zweite Gate-Elektrode auf. Die Gate-Elektroden sind entweder als Schottky-Kontakte auf der Oberfläche des Halbleitersubstrates ausgeführt oder durch eine isolierende Barriere vom Halbleitersubstrat getrennt. Die isolierende Barriere kann beispielsweise durch ein niedrig dotiertes Halbleitermaterial oder ein Oxid, ein Nitrid oder ein Oxynitrid ausgeführt sein. Die Gate-Elektroden selbst sind elektrisch leitfähig und können beispielsweise ein dotiertes Polysilicium, ein Metall oder eine Legierung enthalten oder daraus bestehen.

Source- und Drainkontakte und die Gatelektroden sind beabstandet nebeneinander auf der Oberfläche des Substrates angeordnet, so dass ein elektrischer Kurzschluss zwischen den Kontakten vermieden wird. In einigen Ausführungsformen der Erfindung weisen die Source- und Drainkontakte einen identischen Aufbau auf. In diesem Fall unterscheiden sich Source- und Drainkontakte nur durch die im Betrieb der Strahlungsquelle anzulegende elektrische Spannung.

Bei Betrieb der Strahlungsquelle wird an den Sourcekontakten eine zweite elektrische Spannung angelegt und an den Drainkontakten eine dritte elektrische Spannung. An die Gate-Elektroden wird eine erste elektrische Spannung angelegt, welche so gewählt wird, dass sich im Kanal der Feldeffekttransistoren ein zweidimensionales Elektronengas und eine hinreichende Ladungsträgerdichte ausbildet. Innerhalb des zweidimensionalen Elektronengases (2-DEG) bildet sich bei Betrieb der Strahlungsquelle ein ballistischer Elektronentransport aus. Der ballistische Transport zeichnet sich dadurch aus, dass die Ladungsträger innerhalb des Kanals des Feldeffekttransistors nicht an Phononen oder Störstellen des Kristallgitters gestreut werden oder die Streuung den Transport nicht dominiert. In einigen Ausführungsformen der Erfindung kann die mittlere freie Weglänge doppelt so groß sein wie die Länge des Kanals eines Feldeffekttransistors. In diesem Fall können die Ladungsträger als innerhalb des Kanals strömende Quantenflüssigkeit beschrieben werden. Weiterhin bilden die Kanäle der Feldeffekttransistoren einen Resonator hoher Güte für die entstehenden Plasmonenwellen.

In einigen Ausführungsformen der Erfindung kann die Länge des Kanals jedes der Feldeffekttransistoren kleiner als 300 nm sein. In einigen Ausführungsformen der Erfindung kann die Länge des Kanals jedes der Feldeffekttransistoren kleiner als 30 nm sein. Die genannten Kanallängen sind einerseits mit gängiger Halbleitertechnologie herstellbar und andrerseits klein genug, um bei Halbleiterheterostrukturen oder Elementhalbleitern mit üblichen Verunreinigungen sicher zu stellen, dass die mittlere freie Weglänge zumindest doppelt so groß ist wie die Länge des Kanals eines Feldeffekttransistors. Selbstverständlich kann die Kanallänge auch größer sein, wenn Feldeffekttransistoren mit größerer Ladungsträgerbeweglichkeit zur Verfügung stehen.

Der oben bezeichnete ballistische Transport der Ladungsträger führt zur Anregung von Plasmonen. Die Plasmonen sind als Plasmaschwingung an der Grenzfläche zwischen der Gate-Elektrode und dem Halbleitersubstrat oder an einer Grenzfläche einer Halbleiterheterostruktur lokalisiert. Die Frequenz der im Feldeffekttransistor ausgebildeten Plasmaschwingung kann zwischen etwa 300 GHz und etwa 80 THz liegen. Dementsprechend wird eine elektromagnetische Welle korrespondierender Frequenz ausgesendet.

Die Energie zur Anregung der Plasmonen kann in einigen Ausführungsformen durch einen Gleichstrom zugeführt werden. In einigen Ausführungsformen der Erfindung kann hierzu eine Konstantstromquelle verwendet werden.

In den Kanälen der auf dem Halbleitersubstrat ausgebildeten, erfindungsgemäß gekoppelten Feldeffekttransistoren bildet sich jeweils eine Plasmonenschwingung aus. Dementsprechend sendet jeder Feldeffekttransistor eine elektromagnetische Strahlung aus, welche mit der von weiteren Feldeffekttransistoren ausgehenden Strahlung konstruktiv überlagert werden kann.

Durch die Antennenwirkung der erfindungsgemäßen Anordnung aus zwei oder mehreren Feldeffekttransistoren kann die ausgesendete Strahlung verstärkt werden. Erfindungsgemäß wurde erkannt, dass Feldeffekttransistoren, die periodisch nebeneinander angeordnet sind, die von ihnen jeweils einzeln generierten plasmonischen Schwingungen kollektiv verstärken sowie kollektiv als Antenne wirken, welche diese Schwingungen als Terahertzstrahlung auskoppeln.

Die vorstehend beschriebene Struktur aus zwei gekoppelten Feldeffekttransistoren kann periodisch fortgeführt werden, so dass eine Mehrzahl von Feldeffekttransistoren auf dem Halbleitersubstrat ausgebildet ist. Entsprechend vervielfacht sich die Leistung der ausgesandten elektromagnetischen Strahlung. Beispielsweise können in der beschriebenen Weise etwa 500 bis etwa 2000 Feldeffekttransistoren auf dem Halbleitersubstrat ausgebildet werden. Dementsprechend wird die etwa 500-fache bis etwa 2000-fache Leistung als elektromagnetische Welle abgestrahlt. In einer anderen Ausführungsform der Erfindung kann die Anzahl der Feldeffekttransistoren auf dem Halbleitersubstrat zwischen etwa 800 und etwa 1200 betragen. Dementsprechend wird die etwa 800-fache bis etwa 1200-fache Leistung als elektromagnetische Welle abgestrahlt.

In einigen Ausführungsformen der Erfindung können die geometrischen Abmessungen der Feldeffekttransistoren auf dem Halbleitersubstrat so gewählt sein, dass zumindest die Mehrzahl von Source- und Drainkontakten und optional auch die Gate-Elektroden ein eindimensionales Beugungsgitter für die Reflektion der Plasmonen bilden. In einigen Ausführungsformen der Erfindung kann das Beugungsgitter ein Bragg-Gitter sein oder ein Bragg-Gitter enthalten. Die Einbeziehung der Gate-Elektroden führt dabei zu einer Verkürzung der Gitterkonstanten des Beugungsgitters, so dass bei gleicher Strukturgröße der Strahlungsquelle eine kürzere Wellenlänge der entstehenden elektromagnetischen Strahlung emittiert werden kann. Die Ausführung der Strahlungsquelle als Beugungsgitter führt zu mehrfachen Reflektionen der Plasmonen, wobei diesen Energie aus dem Elektronenstrom in den Kanälen der Feldeffekttransistoren zugeführt wird. Die Energiezufuhr zu den Plasmonen führt zu einem Ansteigen der Intensität der von den Plasmonen emittierten elektromagnetischen Strahlung, da das Beugungsgitter als Antenne für die entstehende elektromagnetische Welle dient.

In allen Ausführungsformen der Erfindung erfüllt die Periode $\Lambda$ des Beugungsgitters folgende Bedingung:

$$\Lambda = \frac{4nL_G}{2k-1} ,$$

wobei $L_G$ die Gatelänge der Feldeffekttransistoren bezeichnet und n und k natürliche Zahlen sind, wobei k Werte von 1 bis 2n annehmen kann. Dieses Verhältnis kann eine konstruktive Überlagerung von Teilwellen ausgehend von einzelnen Transistoren und eine besonders gute Kopplung der Plasmonen an das elektromagnetische Feld der emittierten FIR-Strahlung bewirken. Für die genannten geometrischen Abmessungen ergibt sich nämlich eine Wellenvektoranpassung, d.h. $k_p - k_r = n \cdot G$, wobei $k_p$ der Wellenvektor der Plasmonen ist, $k_r$ der Wellenvektor der elektromagnetischen Strahlung und G der reziproke Gittervektor des Beugungsgitters, d.h.

$$G = \frac{2\pi}{\Lambda} .$$ Die genannten geometrischen Abmessungen führen daher dazu, dass das Beugungsgitter als Antenne für die erzeugte FIR-Strahlung wirkt. Der Parameter n bezeichnet dabei einen Antennenverdünnungsfaktor, d.h. bei n = 1 ist die maximal mögliche Flächendichte von Elementen des Beugungsgitters erreicht.

Für den einfachsten Fall n = k = 1 ergibt sich $\Lambda$ = 4$L_G$. in diesem Fall kann eine kompakte Strahlungsquelle mit großer Effizienz bereitgestellt werden.

In einigen Ausführungsformen der Erfindung sind die Eigenfrequenzen der innerhalb der Kanäle der Feldeffekttransistoren lokalisierten Plasmonen mit der Frequenz der emittierten Strahlung in Resonanz. Hierdurch kann eine besonders effiziente Kopplung des elektromagnetischen Feldes an die Plasmonenschwingung erzielt werden.

In einigen Ausführungsformen der Erfindung weisen die Source- und Drainkontakte und die Gate-Elektroden jeweils die gleiche Breite L auf. Dies erlaubt eine besonders einfache Herstellung der erfindungsgemäßen Strahlungsquelle.

In einigen Ausführungsformen der Erfindung ist der Abstand $L_{SP}$ zwischen einer Gate-Elektrode und einem benachbarten Kontakt dreimal so groß wie die Breite L des Kontaktes bzw. der Gate-Elektrode.

In einigen Ausführungsformen der Erfindung kann die Strahlungsquelle eine Breite von etwa 2,5 $\mu$m bis etwa 250 $\mu$m aufweisen. In diesem Fall entspricht die Breite der Strahlungsquelle in etwa einem Viertel der Wellenlänge der emittierten elektromagnetischen Strahlung, so dass die Strahlungsquelle als $\lambda$/4-Antenne angesehen werden kann und eine effiziente Auskopplung der elektromagnetischen Strahlung sichergestellt ist. Die Abmessungen reichen aus, um etwa 10 bis etwa 8500 Feldeffekttransistoren auf dieser Fläche anzuordnen.

In einigen Ausführungsformen der Erfindung enthält die Strahlungsquelle weiterhin vierte Kontakte, welche benachbart zur Anordnung der ersten Kontakte, der zweiten Kontakte und der dritten Kontakte auf dem Substrat angeordnet sind. In einigen Ausführungsformen der Erfindung können im Betrieb der Vorrichtung an den vierten Kontakten und den benachbarten Source- und Drainkontakten die gleichen elektrischen Potentiale anliegen. Hierdurch können die Plasmonen auf die Kanäle der Feldeffekttransistoren konzentriert und ein Abfall der Intensität an den Rändern des Beugungsgitters vermieden werden.

In einigen Ausführungsformen der Erfindung ist die Beweglichkeit $\mu_e$ der Elektronen im Kanal größer ist als etwa 8000 cm$^2 \cdot$(Vs)$^{-1}$ oder größer ist als etwa 9500 cm$^2 \cdot$(Vs)$^{-1}$. Hierdurch wird eine geringe Dämpfung des Elektronenstroms im Kanal sichergestellt, so dass sich eine Plasmonenschwingung hinreichender Intensität ausbilden kann.

In einigen Ausführungsformen der Erfindung kann die Strahlungsquelle Teil eines Katheters sein, welcher in eine Körperhöhle eines Lebewesens einführbar ist. Beispielsweise kann der Katheter in den Verdauungstrakt, eine Blutbahn, den Wirbelkanal, ein Atmungsorgan oder einen anderen, hier nicht genannten Körperteil eingeführt werden. In anderen Ausführungsformen der Erfindung kann die Strahlungsquelle Teil einer Kapsel sein, welche verschluckt werden kann, so dass eine Diagnostik und/oder Therapie mit FIR-Strahlung während der nachfolgenden Magen-Darm-Passage durchgeführt werden kann. Dies erlaubt den diagnostischen oder therapeutischen Einsatz der FIR-Strahlung unmittelbar an einem Krankheitsherd oder einem Organsystem, so dass eine verbesserte therapeutische Wirkung und/oder eine bessere Diagnostik und/oder verbesserte bildgebende Verfahren ermöglicht werden können. In einigen Ausführungsformen der Erfindung kann die Strahlungsquelle Teil einer Sonde sein, welche in Hohlräume technischer Geräte einführbar ist. Damit können beispielsweise Brennräume, Karosseriehohlräume, Rohrleitungen oder andere technische Geräte von Innen untersucht oder der zeitliche Ablauf von Verbrennungsprozessen kann dargestellt werden.

Nachfolgend soll die Erfindung anhand von Figuren ohne Beschränkung des allgemeinen Erfindungsgedankens näher erläutert werden. Dabei zeigt

Figur 1 die Aufsicht auf eine erfindungsgemäße Strahlungsquelle.

Figur 2 zeigt den Querschnitt durch eine Strahlungsquelle gemäß einer ersten Ausführungsform der Erfindung.

Figur 3 zeigt den Querschnitt durch eine Strahlungsquelle gemäß einer zweiten Ausführungsform der Erfindung.

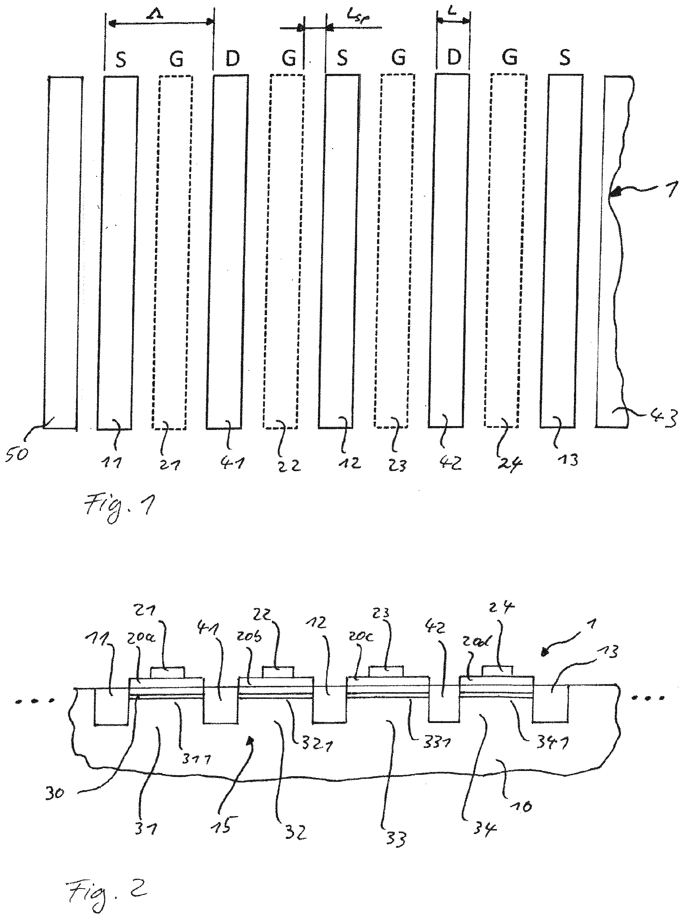

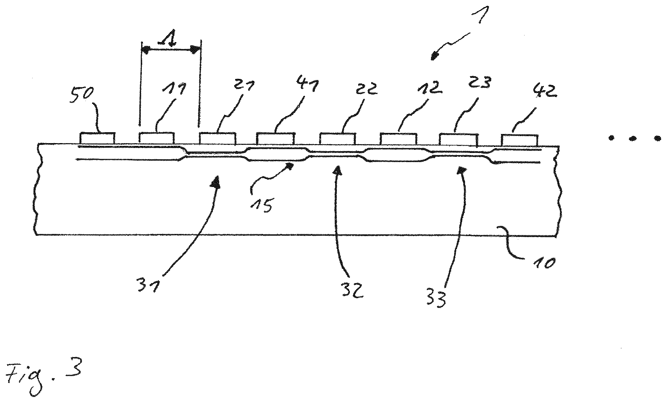

Figur 1 zeigt eine Aufsicht auf eine Strahlungsquelle gemäß der vorliegenden Erfindung. Die Strahlungsquelle 1 enthält ein Halbleitersubstrat, auf welchem eine Mehrzahl von Sourcekontakten 11, 12 und 13, eine Mehrzahl von Drainkontakten 41, 42 und 43 und Gate-Elektroden 21, 22, 23, 24 angeordnet ist. Zwischen dem ersten Sourcekontakt 11 und dem ersten Drainkontakt 41 befindet sich eine erste Gate-Elektrode 21. Zwischen dem ersten Drainkontakt 41 und dem zweiten Sourcekontakt 12 befindet sich eine zweite Gate-Elektrode 22. Zusammen mit den im Substrat 10 angeordneten Schichten, welche nachfolgend anhand der Figur 2 und 3 erläutert werden, bildet der erste Sourcekontakt 11 mit dem ersten Drainkontakt 41 und der ersten Gate-Elektrode 21 einen ersten Feldeffekttransistor 31. Ebenso bildet der erste Drainkontakt 41, der zweite Sourcekontakt 12 und die zweite Gate-Elektrode 22 einen zweiten Feldeffekttransistor 32. Der anhand von Figur 1 exemplarisch erläuterte Aufbau kann periodisch fortgesetzt werden, so dass mehrere 100 oder mehrere 1000 Source- und Drainkontakte und Gate-Elektroden auf der Oberfläche des Halbleitersubstrats angeordnet sind. Dementsprechend ist eine Mehrzahl von Feldeffekttransistoren 31, 32, 33, 34, ... auf dem Substrat angeordnet.

Im dargestellten Ausführungsbeispiel teilen sich benachbarte Transistoren der periodischen Anordnung jeweils einen Source- oder Drainkontakt. In anderen Ausführungsformen der Erfindung können dedizierte Source- und Drainkontakte für jeden Feldeffekttransistor vorhanden sein.

Im dargestellten Ausführungsbeispiel weisen sämtliche Source- und Drainkontakte und Gate-Elektroden dieselbe Breite L auf. In einigen Ausführungsformen der Erfindung kann die Breite L zwischen etwa 3 nm und etwa 300 nm betragen, damit die Eigenfrequenzen der Plasmonen im Kanal der entsprechenden Frequenz der FIR-Strahlung entspricht. Der Abstand $L_{SP}$ zwischen den Gate-Elektroden und den jeweils benachbarten Source- und Drain-Kontakten kann in einigen Ausführungsformen der Erfindung das Dreifache der Breite der Kontakte betragen, also $L_{SP}=3L$. Die periodische Anordnung der Feldeffekttransistoren auf der Oberfläche des Halbleitersubstrates kann eine Breite von etwa 2,5 $\mu$m bis etwa 250 $\mu$m aufweisen, so dass die Breite in etwa ein Viertel der Wellenlänge der von der Strahlungsquelle erzeugten elektromagnetischen Strahlung beträgt.

Die ersten Kontakte 11, die zweiten Kontakte 12, die dritten Kontakte 13 sowie die zugeordneten Gate-Elektroden 21, 22, 23 und 24 können eine Längserstreckung von etwa 100 nm bis etwa 2000 $\mu$m oder von etwa 500 nm bis etwa 2500 $\mu$m oder von etwa 100 nm bis etwa 250 $\mu$m aufweisen.

Weiterhin zeigt Figur 1 im Randbereich optionale vierte Kontakte 50. Diese können auf demselben elektrischen Potential liegen wie die benachbarten Source- oder Drainkontakte 11. Die vierten Kontakte 50 können dazu dienen, den Abfall der Plasmonenwellen in den Randbereichen der Anordnung zu verhindern. In einigen Ausführungsformen der Erfindung können die optionalen vierten Kontakte 50 eine gleiche oder ähnliche Antennenwirkung für die am Rand angeordneten Feldeffekttransistoren, wie für die Transistoren innerhalb der Anordnung zu gewährleisten.

Die periodische Anordnung der Source- und Drainkontakte bildet nicht nur die Feldeffekttransistoren wie oben beschrieben, sondern gleichzeitig ein Beugungsgitter für die in den Kanälen entstehenden Plasmonenwellen. Dazu sind die Sourcekontakte (11, 12, 13) und die Drainkontakte so angeordnet, dass benachbarte Sourcekontakte (11, 12, 13) und Drainkontakte (41, 42, 43) jeweils einen Abstand $\Lambda$ zueinander aufweisen, der folgende Bedingung erfüllt:

$$\Lambda = \frac{4nL_G}{2k-1},$$

wobei $L_G$ die Gatelänge der Feldeffekttransistoren (31, 32, 33, 34) bezeichnet und n und k natürliche Zahlen sind, wobei k Werte von 1 bis 2n annehmen kann. Damit ergibt sich zumindest auf einer Teilfläche eine periodische Anordnung von Source- und/oder Drainkontakten.

Figur 2 zeigt einen Querschnitt durch eine Strahlungsquelle gemäß einer ersten Ausführungsform der Erfindung. Gleiche Bestandteile sind mit gleichen Bezugszeichen versehen, so dass sich die Beschreibung auf die wesentlichen Unterschiede beschränkt. In Figur 2 ist ein Halbleitersubstrat 10 dargestellt, welches beispielsweise einen III-/V-Verbindungshalbleiter enthalten kann. Im Substrat 10 kann eine Heterostruktur 30 ausgebildet sein, welche ein 2-DEG im Kanal 311, 321, 331 und 341 der Feldeffekttransistoren 31, 32, 33 und 34 ausbilden kann.

Weiterhin ist aus Figur 2 ersichtlich, wie Source- und Drainkontakte 11, 12, 13, 41, 42 und 43 in das Substrat 10 eingebracht sind, um entsprechende Feldeffekttransistoren 31, 32, 33 und 34 zu bilden. Die Kontakte 41, 42, 43, 11, 12 und 13 dienen einerseits zur elektrischen Kontaktierung der Halbleiterheterostruktur 30, um einen ballistischen Elektronenstrom zwischen benachbarten Source- und Drain-Kontakten zu ermöglichen. Gleichzeitig werden die sich in den Kanälen 311, 321, 331 und 341 ausbildenden Plasmonen an den Kontakten 41, 42, 43, 11, 12 und 13 zumindest teilweise reflektiert, so dass die Kontakte 41, 42, 43, 11, 12 und 13 auch ein eindimensionales Beugungsgitter 15 für die Plasmonen bilden. Dieses Beugungsgitter wirkt auch als Antenne für die erzeugte FIR-Strahlung. Die Gitterkonstante $\Lambda$ ist durch den Abstand benachbarter Kontakte und deren Breite gegeben, wie in Figur 1 beispielhaft angegeben.

Die Gate-Kontakte 21, 22, 23 und 24 sind auf Isolationsschichten 20a, 20b, 20c und 20d angeordnet. Die Isolationsschichten 20 können beispielsweise ein Oxid, ein Nitrid oder ein Oxynitrid enthalten oder daraus bestehen. Die Gate-Spannung ist beim Betrieb der Strahlungsquelle so gewählt, dass sich genügend Ladungsträger im Kanal des Feldeffekttransistors bilden. Weiterhin kann die dritte elektrische Spannung ($V_{drain}$) so gewählt werden, dass der im Kanal transportierte Strom eine Sättigung erreicht.

In einigen Ausführungsformen der Erfindung kann die dritte elektrische Spannung ($V_{drain}$) in Abhängigkeit der Ladungsträgerbeweglichkeit $\mu$, der effektiven Elektronenmasse $m_{eff}$ und der Gatelänge $L_G$ so gewählt sein, dass

$$\frac{\mu^2 \cdot m_{eff} \cdot V_{Drain}}{e \cdot L_G^2} > 1,$$

wobei e die Elementarladung bezeichnet. In diesem Fall ist die Bedingung für einen ballistischen Transport der Ladungsträger im Kanal gegeben, so dass Plasmonenschwingungen mit hoher Effizienz angeregt werden. Die dritte elektrische Spannung ($V_{drain}$) Spannung wird dabei in Abhängigkeit der Gatelänge $L_G$ unterhalb der materialabhängigen Durchbruchfeldstärke gewählt. Beispielsweise kann die Feldstärke $V_{Drain}/L_G$ kleiner sein als $1 \cdot 10^5$ V·cm$^{-1}$, wenn die Strahlungsquelle Germanium enthält oder daraus besteht. Die Feldstärke $V_{Drain}/L_G$ kann kleiner sein als $3 \cdot 10^5$ V·cm$^{-1}$, wenn die Strahlungsquelle Silizium enthält oder daraus besteht. Die Feldstärke $V_{Drain}/L_G$ kann kleiner sein als $4 \cdot 10^5$ V·cm$^{-1}$, wenn die Strahlungsquelle GaAs enthält oder daraus besteht. Die Feldstärke $V_{Drain}/L_G$ kann kleiner sein als $2.2 \cdot 10^6$ V·cm$^{-1}$, wenn die Strahlungsquelle SiC enthält oder daraus besteht. Die Feldstärke $V_{Drain}/L_G$ kann kleiner sein als $5,0 \cdot 10^5$ V·cm$^{-1}$, wenn die Strahlungsquelle InP enthält oder daraus besteht. Die Feldstärke $V_{Drain}/L_G$ kann kleiner sein als $5,0 \cdot 10^6$ V·cm$^{-1}$, wenn die Strahlungsquelle GaN enthält oder daraus besteht.

In einigen Ausführungsformen der Erfindung kann die Gatelänge $L_G$ zumindest eines Transistors der Strahlungsquelle in Abhängigkeit der Materialparameter Ladungsträgerbeweglichkeit $\mu$ und der effektiven Elektronenmasse $m_{eff}$ so gewählt sein, dass

$$\frac{\mu^2 \cdot m_{eff}}{e \cdot L_G} \geq a \ ,$$

ist, wobei e die Elementarladung bezeichnet und a eine Konstante ist. In einigen Ausführungsformen der Erfindung kann die Konstante a aus dem Intervall von $4 \cdot 10^{-7}$ $cm \cdot V^{-1}$ bis $1 \cdot 10^{-5}$ $cm \cdot V^{-1}$ gewählt sein. Die Konstante a kann größer sein als $1 \cdot 10^{-5}$ $cm \cdot V^{-1}$, wenn die Strahlungsquelle Germanium enthält oder daraus besteht. Die Konstante a kann größer sein als $3,3 \cdot 10^{-6}$ $cm \cdot V^{-1}$, wenn die Strahlungsquelle Silizium enthält oder daraus besteht. Die Konstante a kann größer sein als $2,5 \cdot 10^{-6}$ $cm \cdot V^{-1}$, wenn die Strahlungsquelle GaAs enthält oder daraus besteht. Die Konstante a kann größer sein als $4,5 \cdot 10^{-7}$ $cm \cdot V^{-1}$, wenn die Strahlungsquelle SiC enthält oder daraus besteht. Die Konstante a kann größer sein als $2,0 \cdot 10^{-7}$ $cm \cdot V^{-1}$, wenn die Strahlungsquelle GaN enthält oder daraus besteht. Die Konstante a kann größer sein als $2,0 \cdot 10^{-6}$ $cm \cdot V^{-1}$, wenn die Strahlungsquelle InP enthält oder daraus besteht.

Es ist darauf hinzuweisen, dass die Halbleiterheterostruktur 30 in anderen Ausführungsformen der Erfindung auch entfallen kann, so dass sich das zweidimensionale Elektronengas aufgrund der durch die Gate-Spannung induzierten Bandverbiegung einstellt. In einigen Ausführungsform können zumindest zwei Kontakte 11, 41 und zumindest eine Gate-Elektrode 21 einen Feldeffekttransistor mit hoher Elektronenmobilität (HEMT) bilden. Die Beweglichkeit $\mu_e$ der Elektronen im Kanal kann dann größer sein als etwa 8000 $cm^2 \cdot (Vs)^{-1}$ oder größer als etwa 9500 $cm^2 \cdot (Vs)^{-1}$.

Die sich in der Halbleiterheterostruktur 30 bzw. unter einer Grenzfläche der Gate-Elektroden ausbildenden Plasmonenwellen erzeugen jeweils elektromagnetische FIR-Strahlung. Die jeweiligen von den Feldeffekttransistoren abgestrahlten Teilintensitäten können sich addieren, so dass sich eine Strahlungsquelle hoher Intensität und/oder hoher Brillanz ergibt.

Figur 3 zeigt eine zweite Ausführungsform der vorliegenden Erfindung im Schnitt. Gleiche Bestandteile der Erfindung sind mit gleichen Bezugszeichen versehen, so dass sich die nachfolgende Beschreibung auf die wesentlichen Unterschiede beschränkt.

Auch die zweite Ausführungsform weist ein Halbleitersubstrat 10 auf. Auf dem Halbleitersubstrat 10 kann eine optionale Halbleiterheterostruktur abgeschieden sein, welche ein 2-DEG mit großer Ladungsträgerbeweglichkeit bereitstellen kann. Im Unterschied zur ersten Ausführungsform sind die Sourcekontakte 11 und 12, die Drainkontakte 41 und 42 und die Gateelektroden 21, 22 und 23 nicht in Gräben innerhalb des Substrats 10 angeordnet. Vielmehr sind die Kontakte 41, 42, 11 und 12 als Ohm'sche Kontakte auf der Oberfläche des Halbleitersubstrates ausgebildet. Hierdurch kann die Herstellung der Strahlungsquelle wesentlich erleichtert sein.

Auch die Gate-Elektroden 21, 22 und 23 sind als Metallschicht auf der Oberfläche des Halbleitersubstrates 10 ausgebildet. Die Gate-Elektroden 21, 22 und 23 sind als Schottky-Kontakte ausgebildet. In einigen Ausführungsformen der Erfindung kann dies dadurch erfolgen, dass ein Metall oder eine Legierung mit größerer oder geringerer Austrittsarbeit verwendet wird. Die Herstellung der Strahlungsquelle 1 erfordert dann lediglich die Herstellung der entsprechenden Kontakte und Gate-Elektroden durch Abscheiden und Strukturieren zweier unterschiedlicher Metallschichten auf dem Halbleitersubstrat 10 mit der Heterostruktur 30.

In einigen Ausführungsformen der Erfindung kann die Oberfläche des Halbleitersubstrates 10 zumindest in Teilflächen durch Ätzen entfernt werden, um die Heterostruktur 30 freizulegen. Hierdurch kann die Herstellung der Ohm'schen Kontakte bzw. der Schottky-Kontakte erleichtert sein oder deren Qualität verbessert werden. In einigen Ausführungsformen der Erfindung kann das Halbleitersubstrat 10 zumindest in Teilflächen leitfähig dotiert sein, um Ohm'sche Kontakte besserer Qualität bereitzustellen. In einigen Ausführungsformen der Erfindung kann das Halbleitersubstrat 10 zumindest in Teilflächen gering dotiert sein und/oder isolierend sein und/oder gering leitfähig sein, um Schottky-Kontakte besserer Qualität bereitzustellen.

Da die Kontakte 41, 42, 11, und 12 Ohm'sche Kontakte sind, die Gate-Elektroden jedoch Schottky-Kontakte, ist deren Wirkung auf die Elektronen in der Heterostruktur 30 unterschiedlich. Jedoch weisen sämtliche Metallisierungen einen ähnlichen Einfluss auf die sich ausbildenden Plasmonen auf, so dass die Gitterkonstante Λ des sich ausbildenden Beugungsgitters 15 bzw. der durch das Beugungsgitter 15 gebildeten Antenne kleiner ist als im ersten Ausführungsbeispiel. Die kleinere Gitterkonstante Λ kann sich vorteilhaft auf die Ausbildung und Verstärkung der Plasmonen und/oder die Abstrahlung der FIR-Strahlung bei Betrieb der Strahlungsquelle auswirken. Hierdurch kann die in Figur 3 dargestellte zweite Ausführungsform eine größere Intensität elektromagnetischer Strahlung und/oder eine Strahlung mit höherer Frequenz bereitstellen. Die in den Kanälen der Feldeffekttransistoren entstehenden Plasmonen koppeln elektromagnetisch an das durch die Metallisierungen 41, 42, 11, 12, 21, 22 und 23 gebildete Gitter. Dieses wirkt wie eine Antenne, so dass die Plasmonen in freie elektromagnetische Strahlung umgewandelt werden.

In einigen Ausführungsformen der Erfindung können das Halbleitersubstrat 10 und/oder die Ohm'sche Kontakte 41, 42, 11, und 12 und/oder die Schottky-Kontakte 21, 22 und 23 aus einem Material bestehen oder ein solches erhalten, welches FIR-Strahlung in geringem Maß absorbiert.

1. Ausführungsbeispiel

Eine Strahlungsquelle gemäß der Erfindung enthält Feldeffekttransistoren, welche auf einem Halbleitersubstrat aus GaAs hergestellt sind. Die Beweglichkeit

$\mu_e$ der Elektronen beträgt $\mu_e$ = 9500 cm$^2 \cdot$(Vs)$^{-1}$. Die effektive Masse $m_{eff}$ der Elektronen im Halbleiter beträgt 0,067$\cdot m_0$, wobei $m_0$ die Masse des freien Elektrons bezeichnet. Die einzelnen Feldeffekttransistoren der Strahlungsquelle weisen jeweils eine Gatelänge von 300 nm auf. Die Feldeffekttransistoren werden mit einer dritten Spannung $V_{Drain}$ von 1 V betrieben. Damit gilt:

$$\frac{\mu^2 \cdot m_{eff} \cdot V_{Drain}}{e \cdot L_G^2} = 4,06 > 1 \ ,$$

d.h. es tritt ein ballistischer Transport der Elektronen im Kanal der Feldeffekttransistoren auf. Damit kann eine solche Strahlungsquelle FIR-Strahlung emittieren.

2. Ausführungsbeispiel

Eine Strahlungsquelle gemäß der Erfindung enthält Feldeffekttransistoren, welche auf einem Halbleitersubstrat aus Silizium angeordnet sind. Die Beweglichkeit $\mu_e$ der Elektronen beträgt $\mu_e$ = 300 cm$^2 \cdot$(Vs)$^{-1}$. Die effektive Masse $m_{eff}$ der Elektronen im Halbleiter beträgt 0,36$\cdot m_0$, wobei $m_0$ die Masse des freien Elektrons bezeichnet. Die einzelnen Feldeffekttransistoren der Strahlungsquelle weisen jeweils eine Gatelänge von 15 nm auf. Die Feldeffekttransistoren werden mit einer dritten Spannung $V_{Drain}$ von 1 V betrieben. Damit gilt:

$$\frac{\mu^2 \cdot m_{eff} \cdot V_{Drain}}{e \cdot L_G^2} = 8,19 > 1 \ ,$$

d.h. es tritt ein ballistischer Transport der Elektronen im Kanal der Feldeffekttransistoren auf. Damit kann eine solche Strahlungsquelle FIR-Strahlung emittieren.

3. Ausführungsbeispiel

Eine Strahlungsquelle gemäß der Erfindung enthält Feldeffekttransistoren, welche auf einem Halbleitersubstrat aus Silizium angeordnet sind. Die Beweglichkeit $\mu_e$ der Elektronen beträgt $\mu_e$ = 300 cm$^2 \cdot$(Vs)$^{-1}$. Die effektive Masse $m_{eff}$ der Elektronen im Halbleiter beträgt 0,36$\cdot m_0$, wobei $m_0$ die Masse des freien Elektrons bezeichnet. Die einzelnen Feldeffekttransistoren der Strahlungsquelle weisen jeweils eine Gatelänge von 30 nm auf. Die Feldeffekttransistoren werden mit einer dritten Spannung $V_{Drain}$ von 1 V betrieben. Damit gilt:

$$\frac{\mu^2 \cdot m_{eff} \cdot V_{Drain}}{e \cdot L_G^2} = 2,36 > 1 \ ,$$

d.h. es tritt gerade noch ein ballistischer Transport der Elektronen im Kanal der Feldeffekttransistoren auf. Damit kann auch eine solche Strahlungsquelle FIR-Strahlung emittieren.

Vergleichsbeispiel

Ein Feldeffekttransistor ist auf einem Halbleitersubstrat aus Silizium angeordnet. Die Beweglichkeit $\mu_e$ der Elektronen beträgt $\mu_e$ = 300 cm$^2 \cdot$(Vs)$^{-1}$. Die effektive Masse $m_{eff}$ der Elektronen im Halbleiter beträgt 0,36$\cdot m_0$, wobei $m_0$ die Masse des freien Elektrons bezeichnet. Die einzelnen Feldeffekttransistoren der Strahlungsquelle weisen jeweils eine Gatelänge von 100 nm auf. Die Feldeffekttransistoren werden mit einer dritten Spannung $V_{Drain}$ von 1 V betrieben. Damit gilt:

$$\frac{\mu^2 \cdot m_{eff} \cdot V_{Drain}}{e \cdot L_G^2} = 0,18 < 1 \ ,$$

d.h. es tritt kein ballistischer Transport der Elektronen im Kanal des Feldeffekttransistors auf. Somit kann auf der Basis solcher Transistoren keine Strahlungsquelle gemäß der Erfindung realisiert werden.

**Patentansprüche**

**1.** Strahlungsquelle (1) mit zumindest einem Halbleitersubstrat (10), auf welchem zumindest zwei Feldeffekttransistoren (31, 32, 33, 34) ausgebildet sind, welche jeweils eine Gateelektrode (21, 22, 23, 24) mit einer Gatelänge $L_G$, einen Sourcekontakt (11, 12, 13) und einen Drainkontakt (41, 42, 43) enthalten, welche einen Kanal (311, 321, 331, 341) begrenzen,
**dadurch gekennzeichnet, dass**
die zumindest zwei Feldeffekttransistoren (31, 32, 33, 34) nebeneinander auf dem Substrat angeordnet sind, wobei jeder Feldeffekttransistor (31, 32, 33, 34) genau eine Gateelektrode (21, 22, 23, 24) aufweist und zwischen zwei benachbarten Gateelektroden (21, 22, 23, 24) zumindest ein Sourcekontakt (11, 12, 13) und/oder zumindest ein Drainkontakt angeordnet ist, wobei benachbarte Sourcekontakte (11, 12, 13) und/oder Drainkontakte (41, 42, 43) jeweils einen Abstand $\Lambda$ zueinander aufweisen, der folgende Bedingung erfüllt:

$$\Lambda = \frac{4nL_G}{2k-1} \ ,$$

wobei $L_G$ die Gatelänge der Feldeffekttransistoren (31, 32, 33, 34) bezeichnet und n und k natürliche Zahlen sind, wobei k Werte von 1 bis 2n annehmen kann.

**2.** Strahlungsquelle nach Anspruch 1, **dadurch gekennzeichnet, dass** im Kanal (311, 321, 331, 341) der Feldeffekttransistoren (31, 32, 33, 34) zumindest bei Betrieb der Strahlungsquelle ein zweidimensionales Elektronengas ausbildbar ist.

**3.** Strahlungsquelle nach Anspruch 1 oder 2, **dadurch gekennzeichnet, dass** die Mehrzahl von Sourcekontakten (11, 12, 13) und Drainkontakten (41, 42, 43) ein eindimensionales Beugungsgitter (15) für Plasmonen bilden und/oder
dass die Mehrzahl von Sourcekontakten (11, 12, 13) und Drainkontakten (41, 42, 43) zwischen etwa 1000 und etwa 4000 oder zwischen etwa 1600 und etwa 2400 beträgt und/oder
dass die Gateelektroden (21, 22, 23, 24), die Sourcekontakte (11, 12, 13) und die Drainkontakte (41, 42, 43) parallel zueinander angeordnet sind.

**4.** Strahlungsquelle nach Anspruch 3, **dadurch gekennzeichnet, dass** die Sourcekontakte (11, 12, 13) und die Drainkontakte und die Gate-Elektroden (21, 22, 23, 24) jeweils die gleiche Breite $L_G$ aufweisen.

**5.** Strahlungsquelle nach einem der Ansprüche 1 bis 4, **dadurch gekennzeichnet, dass** die Kanallänge weniger als 300 nm beträgt oder dass die Kanallänge weniger als 30 nm beträgt.

**6.** Strahlungsquelle nach einem der Ansprüche 1 bis 5, **dadurch gekennzeichnet, dass** die mittlere freie Weglänge der Elektronen im Kanal (311, 321, 331, 341) größer als das doppelte der Gatelänge $L_G$ ist.

**7.** Strahlungsquelle nach einem der Ansprüche 1 bis 6, **dadurch gekennzeichnet, dass** die Beweglichkeit $\mu_e$ der Elektronen im Kanal größer ist als etwa 8000 cm$^2$·(Vs)$^{-1}$ oder
dass die Beweglichkeit $\mu_e$ der Elektronen im Kanal größer ist als etwa 9500 cm$^2$·(Vs)$^{-1}$.

**8.** Strahlungsquelle nach einem der Ansprüche 1 bis 7, **dadurch gekennzeichnet, dass** das Halbleitersubstrat (10) Si oder einen III-V-Verbindungshalbleiter enthält oder daraus besteht oder
dass das Halbleitersubstrat (10) InP und/oder GaAs und/oder InAlGaAs und/oder InGaAs und/oder InAlAs enthält oder daraus besteht.

**9.** Strahlungsquelle nach einem der Ansprüche 1 bis 8, **dadurch gekennzeichnet, dass** die Gatelänge $L_G$ zumindest eines Transistors der Strahlungsquelle in Abhängigkeit der Materialparameter Ladungsträgerbeweglichkeit $\mu$ und der effektiven Elektronenmasse $m_{eff}$ so gewählt sein, dass

$$\frac{\mu^2 \cdot m_{eff}}{e \cdot L_G} \geq a \ ,$$

ist, wobei e die Elementarladung bezeichnet und a eine Konstante ist,
welche insbesondere aus dem Intervall von 4·10$^{-7}$ cm·V$^{-1}$ bis 1·10$^{-5}$ cm·V$^{-1}$ gewählt ist.

**10.** Strahlungsquelle nach einem der Ansprüche 1 bis 9, weiterhin enthaltend eine Konstantstromquelle.

**11.** Verfahren zur Erzeugung elektromagnetischer Strahlung mit einer Vakuumwellenlänge zwischen etwa 10 μm und etwa 1 mm, bei welchem eine Anordnung (1) mit zumindest zwei Feldeffekttransistoren (31, 32, 33, 34) verwendet wird, welche auf einem Halbleitersubstrat angeordnet sind und jeweils eine Gateelektrode (21, 22, 23, 24), einen Sourcekontakt (11, 12, 13) und einen Drainkontakt (41, 42, 43) enthalten, welche einen Kanal (311, 321, 331, 341) begrenzen, wobei jeder Feldeffekttransistor (31, 32, 33, 34) genau eine Gateelektrode (21, 22, 23, 24) aufweist und zwischen zwei benachbarten Gateelektroden (21, 22, 23, 24) zumindest ein Sourcekontakt (11, 12, 13) und/oder zumindest ein Drainkontakt (41, 42, 43) angeordnet ist, wobei an die Gate-Elektroden (21, 22, 23, 24) eine erste elektrische Spannung ($V_{gate}$) und an die Sourcekontakte (11, 12, 13) eine zweite elektrische Spannung ($V_{source}$) und an die Drainkontakte (41, 42, 43) eine dritte elektrische Spannung ($V_{drain}$) angelegt wird, so dass sich zwischen den Sourcekontakten und den Drainkontakten jeweils ein ballistischer Elektronenstrom ausbildet, welcher Plasmonenschwingungen zumindest in zumindest einem Kanal der Feldeffekttransistoren (31, 32, 33, 34) anregt.

**12.** Verfahren nach Anspruch 11, **dadurch gekennzeichnet,**
**dass** die zweite elektrische Spannung ($V_{source}$) null bzw. ein Massepotential ist und/oder
**dass** die dritte elektrische Spannung ($V_{drain}$) so gewählt ist, dass der dem Sourcekontakt (12) zu- oder abgeführte Strom eine Sättigung erreicht und/oder die dritte elektrische Spannung ($V_{drain}$) in Abhängigkeit der Ladungsträgerbeweglichkeit $\mu$, der effektiven Elektronenmasse $m_{eff}$ und der Gatelänge $L_G$ so gewählt ist, dass

$$\frac{\mu^2 \cdot m_{eff} \cdot V_{Drain}}{e \cdot L_G^2} > 1 \ ,$$

wobei e die Elementarladung bezeichnet.

13. Verfahren nach einem der Ansprüche 11 oder 12, **dadurch gekennzeichnet, dass** sich zwischen den Source- und Drainkontakten jeweils ein zweidimensionales Elektronengas ausbildet.

14. Verfahren nach einem der Ansprüche 11 bis 13, **dadurch gekennzeichnet, dass** der Anordnung ein konstanter elektrischer Strom zugeführt wird.

15. Verfahren nach einem der Ansprüche 11 bis 14, **dadurch gekennzeichnet, dass** die in den jeweiligen Feldeffekttransistoren (31, 32, 33, 34) angeregten elektromagnetischen Wellen konstruktiv miteinander interferieren.

**Claims**

1. Radiation source (1) having at least one semiconductor substrate (10), on which at least two field effect transistors (31, 32, 33, 34) are formed, each containing a gate electrode (21, 22, 23, 24) with a gate length $L_G$, a source contact (11, 12, 13) and a drain contact (41, 42, 43), which delimit a channel (311, 321, 331, 341),
**characterized in that**
the at least two field effect transistors (31, 32, 33, 34) are arranged next to one another on the substrate, wherein each field effect transistor (31, 32, 33, 34) has precisely one gate electrode (21, 22, 23, 24), and at least one source contact (11, 12 ,13) and/or at least one drain contact is arranged between two adjacent gate electrodes (21, 22, 23, 24), wherein adjacent source contacts (11, 12, 13) and/or drain contacts (41, 42, 43) have in each case a distance $\Lambda$ from one another that complies with the following condition:

$$\Lambda = \frac{4nL_G}{2k-1},$$

wherein $L_G$ is the gate length of the field effect transistors (31, 32, 33, 34) and n and $k$ are natural numbers, wherein $k$ can adopt values from 1 to 2n.

2. Radiation source according to claim 1, **characterized in that** a two-dimensional electron gas can be formed in the channel (311, 321, 331, 341) of the field effect transistors (31, 32, 33, 34), at least when the radiation source is operated.

3. Radiation source according to claim 1 or 2, **characterized in that** the plurality of source contacts (11, 12, 13) and drain contacts (41, 42, 43) form a one-dimensional diffraction grating (15) for plasmons and/or
that the plurality of source contacts (11, 12, 13) and drain contacts (41, 42, 43) is between about 1000 and about 4000 or between about 1600 and about 2400 and/or
that the gate electrodes (21, 22 ,23, 24), the source contacts (11, 12, 13) and the drain contacts (41, 42, 43) are arranged in parallel to one another.

4. Radiation source according to claim 3, **characterized in that** the source contacts (11, 12, 13) and the drain contacts and the gate electrodes (21, 22, 23, 24) all have the same with $L_G$.

5. Radiation source according to any of claims 1 to 4, **characterized in**
**that** the channel length is less than 300 nm or that the channel length is less than 30 nm.

6. Radiation source according to any of claims 1 to 5, **characterized in**
**that** the mean free path of the electrons in the channel (311, 321, 331, 341) is longer than twice the gate length $L_G$.

7. Radiation source according to any of claims 1 to 6, **characterized in**
**that** the mobility $\mu_e$ of the electrons in the channel is greater than about 8000 cm$^2$·(Vs)$^{-1}$ or that the mobility $\mu_e$ of the electrons in the channel is greater than about 9500 cm$^2$·(Vs)$^{-1}$.

8. Radiation source according to any of claims 1 to 7, **characterized in**
**that** the semiconductor substrate (10) contains, or consists of, Si or a III-V-compound semiconductor or **that** the semiconductor substrate (10) contains, or consists of, InP and/or GaAs and/or InAlGaAs and/or InGaAs and/or InAlAs.

9. Radiation source according to any of claims 1 to 8, **characterized in**
**that** the gate length $L_G$ of at least one transistor of the radiation source is selected in accordance with the material parameters, charge carrier mobility $\mu$ and the effective electron mass $m_{eff}$ in such a way that

$$\frac{\mu^2 \cdot m_{eff}}{e \cdot L_G} \geq a,$$

wherein e is the elementary charge and a is a constant which is in particular selected from the interval of 4·10$^{-7}$ cm·V$^{-1}$ to 1·10$^{-5}$ cm·V$^{-1}$.

10. Radiation source according to any of claims 1 to 9, further containing a constant current source.

**11.** Method for producing electromagnetic radiation having a vacuum wavelength between about 10 $\mu$m and about 1 mm, which uses an arrangement (1) with at least two field effect transistors (31, 32, 33, 34) that are arranged on a semiconductor substrate and contain in each case a gate electrode (21, 22, 23, 24), a source contact (11, 12, 13) and a drain contact (41, 42, 43), which delimit a channel (311, 321, 331, 341), wherein each field effect transistor (31, 32, 33, 34) has precisely one gate electrode (21, 22, 23, 24), and at least one source contact (11 ,12, 13) and/or at least one drain contact (41, 42, 43) is arranged between two adjacent gate electrodes (21, 22, 23, 24), wherein a first electric voltage ($V_{gate}$) is applied to the gate electrodes (21, 22, 23, 24) and a second electric voltage ($V_{source}$) is applied to the source contacts (11, 12, 13) and a third electric voltage ($V_{drain}$) is applied to the drain contacts (41, 42, 43) so as to form in each case one ballistic electron flow between the source contacts and the drain contacts, said electron flow exciting plasmon oscillations at least in at least one channel of the field effect transistors (31, 32, 33, 34).

**12.** Method according to claim 11, **characterized in that** the second electric voltage ($V_{source}$) is zero and/or a mass potential and/or that the third electric voltage ($V_{drain}$) is selected in such a way that the current supplied to or discharged from the source contact (12) reaches saturation and/or the third electric voltage ($V_{drain}$) is selected in accordance with the charge carrier mobility $\mu$, the effective electron mass $m_{eff}$ and the gate length $L_G$ in such a way that

$$\frac{\mu^2 \cdot m_{eff} \cdot V_{Drain}}{e \cdot L_G{}^2} > 1 \,,$$

wherein e is the elementary charge.

**13.** Method according to any of claims 11 or 12, **characterized in that** a two-dimensional electron gas is formed in each case between the source and drain contacts.

**14.** Method according to any of claims 11 to 13, **characterized in that** a constant electric current is supplied to the arrangement.

**15.** Method according to any of claims 11 to 14, **characterized in that** the electromagnetic waves excited in the respective field effect transistors (31, 32, 33, 34) interfere with one another in a constructive way.

**Revendications**

**1.** Source de rayonnement (1), comprenant au moins un substrat en semiconducteur (10) sur lequel sont formés au moins deux transistors à effet de champ (31, 32, 33, 34), lesquels contiennent respectivement une électrode de gâchette (21, 22, 23, 24) ayant une longueur de gâchette $L_G$, un contact de source (11, 12, 13) et un contact de drain (41, 42, 43), lesquels délimitent un canal (311, 321, 331, 341),
**caractérisée en ce que**
les au moins deux transistors à effet de champ (31, 32, 33, 34) sont disposés les uns à côté des autres sur le substrat, chaque transistor à effet de champ (31, 32, 33, 34) possédant exactement une électrode de gâchette (21, 22, 23, 24) et au moins un contact de source (11, 12, 13) et/ou au moins un contact de drain étant disposés entre deux électrodes de gâchette (21, 22, 23, 24) voisines, les contacts de source (11, 12, 13) et/ou contacts de drain (41, 42, 43) voisins possédant respectivement un écart A entre eux, lequel remplit la condition suivante :

$$\Lambda = \frac{4nL_G}{2k-1},$$

où $L_G$ désigne la longueur de gâchette des transistors à effet de champ (31, 32, 33, 34) et n et k sont des nombres naturels, k pouvant prendre les valeurs de 1 à 2n.

**2.** Source de rayonnement selon la revendication 1, **caractérisée en ce qu'**un gaz d'électrons bidimensionnel peut être formé dans le canal (311, 321, 331, 341) des transistors à effet de champ (31, 32, 33, 34) au moins lors du fonctionnement de la source de rayonnement.

**3.** Source de rayonnement selon la revendication 1 ou 2, **caractérisée en ce que** la pluralité de contacts de source (11, 12, 13) et de contacts de drain (41, 42, 43) forment un réseau de diffraction (15) unidimensionnel pour des plasmons
et/ou
**en ce que** la pluralité de contacts de source (11, 12, 13) et de contacts de drain (41, 42, 43) est comprise entre environ 1000 et environ 4000 ou entre environ 1600 et environ 2400
et/ou
**en ce que** les contacts de source (11, 12, 13) et les contacts de drain (41, 42, 43) sont disposés en parallèle les uns avec les autres.

**4.** Source de rayonnement selon la revendication 3, **caractérisée en ce que** les contacts de source (11, 12, 13) et les contacts de drain ainsi que les électrodes de gâchette (21, 22, 23, 24) présentent respectivement la même largeur $L_G$.

5. Source de rayonnement selon l'une des revendications 1 à 4, **caractérisée en ce que** la longueur de canal est inférieure à 300 nm ou **en ce que** la longueur de canal est inférieure à 30 nm.

6. Source de rayonnement selon l'une des revendications 1 à 5, **caractérisée en ce que** la longueur de trajet libre moyenne des électrons dans le canal (311, 321, 331, 341) est supérieure au double de la longueur de gâchette $L_G$.

7. Source de rayonnement selon l'une des revendications 1 à 6, **caractérisée en ce que** la mobilité $\mu_e$ des électrons dans le canal est supérieure à environ 8000 cm$^2$.(Vs)$^{-1}$ ou **en ce que** la mobilité $\mu_e$ des électrons dans le canal est supérieure à environ 9500 cm$^2$.(Vs)$^{-1}$.

8. Source de rayonnement selon l'une des revendications 1 à 7, **caractérisée en ce que** le substrat en semiconducteur (10) contient du Si ou un semiconducteur à liaison III-V ou en est composé, ou **en ce que** le substrat en semiconducteur (10) contient de l'InP et/ou du GaAs et/ou de l'InAlGaAs et/ou de l'InGaAs et/ou de l'InAlAs ou en est composé.

9. Source de rayonnement selon l'une des revendications 1 à 8, **caractérisée en ce que** la longueur de gâchette $L_G$ d'au moins un transistor de la source de rayonnement est choisie en fonction du paramètre de matériau mobilité des porteurs de charge $\mu$ et de la masse des électrons effective $m_{eff}$ de telle sorte que

$$\frac{\mu^2 \cdot m_{eff}}{e \cdot L_G} \geq a,$$

où e désigne la charge élémentaire et a est une constante, laquelle est notamment choisie dans l'intervalle de 4.10$^{-7}$ cm.V$^{-1}$ à 1.10$^{-5}$ cm.V$^{-1}$.

10. Source de rayonnement selon l'une des revendications 1 à 9, contenant en outre une source de courant constant.

11. Procédé de génération d'un rayonnement électromagnétique ayant une longueur d'onde dans le vide comprise entre environ 10 $\mu$m et environ 1 mm, avec lequel est utilisé un arrangement comprenant au moins deux transistors à effet de champ (31, 32, 33, 34), lesquels sont disposés sur un substrat en semiconducteur et contiennent respectivement une électrode de gâchette (21, 22, 23, 24), un contact de source (11, 12, 13) et un contact de drain (41, 42, 43), lesquels délimitent un canal (311, 321, 331, 341), chaque transistor à effet de champ (31, 32, 33, 34) possédant exactement une électrode de gâchette (21, 22, 23, 24) et au moins un contact de source (11, 12, 13) et/ou au moins un contact de drain (41, 42, 43) étant disposés entre deux électrodes de gâchette (21, 22, 23, 24) voisines, une première tension électrique ($V_{gate}$) étant appliquée aux électrodes de gâchette (21, 22, 23, 24) et une deuxième tension électrique ($V_{source}$) aux contacts de source (11, 12, 13) et une troisième tension électrique ($V_{drain}$) aux contacts de drain (41, 42, 43), de telle sorte qu'un courant d'électrons balistique se forme respectivement entre les contacts de source et les contacts de drain, lequel excite des oscillations plasmons au moins dans au moins un canal des transistors à effet de champ (31, 32, 33, 34).

12. Procédé selon la revendication 11, **caractérisé en ce que** la deuxième tension électrique ($V_{source}$) est nulle ou un potentiel de masse et/ou **en ce que** la troisième tension électrique ($V_{drain}$) est choisie de telle sorte que le courant acheminé vers ou extrait du contact de source (12) atteint une saturation et/ou la troisième tension électrique ($V_{drain}$) est choisie en fonction de la mobilité des porteurs de charge $\mu$, de la masse des électrons effective $m_{eff}$ de et de la longueur de gâchette $L_G$ de telle sorte que

$$\frac{\mu^2 \cdot m_{eff} \cdot V_{drain}}{e \cdot L_G{}^2} > 1,$$

où e désigne la charge élémentaire.

13. Procédé selon l'une des revendications 11 ou 12, **caractérisé en ce qu'**un gaz d'électrons bidimensionnel se forme respectivement entre les contacts de source et de drain.

14. Procédé selon l'une des revendications 11 à 13, **caractérisé en ce qu'**un courant électrique constant est acheminé à l'arrangement.

15. Procédé selon l'une des revendications 11 à 14, **caractérisé en ce que** les ondes électromagnétiques excitées dans les transistors à effet de champ (31, 32, 33, 34) respectifs interfèrent constructivement les unes avec les autres.

Fig. 1

Fig. 2

Fig. 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- WO 2013016601 A1

### In der Beschreibung aufgeführte Nicht-Patentliteratur

- **AUS T. OTSUJI ; Y.M. MEZIANI ; T. NISHIMURA ; T. SUEMITSU ; W. KNAP ; E. SANO ; T. ASANO ; V.V. POPOV.** Emission of terahertz radiation from dual grating gate plasmon-resonant emitters fabricated with InGaP/InGaAs/GaAs material systems. *J. Phys.: Condens. Matter,* 2008, vol. 20, 384206

- **SHUR, M.S ; LU, J.-Q ; DYAKONOV, M.I.** Plasma wave electronics: terahertz sources and detectors using two dimensional electronic fluid in high electron mobility transistors. *Terahertz Electronics Proceedings, 1998. THz Ninety Eight. 1998 IEEE Sixth International Conference,* 127-130